# EUROPÄISCHE PATENTSCHRIFT

(11) **EP 2 529 185 B1**
(45) Veröffentlichungstag und Bekanntmachung des Hinweises auf die Patenterteilung: **31.08.2016**
(21) Anmeldenummer: 10790784.2
(22) Anmeldetag: 14.12.2010
(51) Int. Cl.: G01D 4/00, G01R 19/25

(54) **VERFAHREN ZUR IDENTIFIKATION VON VERBRAUCHERN BZW. ERZEUGERN IN EINEM PNEUMATISCHEN, HYDRAULISCHEN ODER ELEKTRISCHEN NETZ**
METHOD OF IDENTIFYING CONSUMERS OR PRODUCERS IN A PNEUMATIC, HYDRAULIC OR ELECTRIC NETWORK
PROCÉDÉ D'IDENTIFICATION DE CONSOMMATEURS OU DE GÉNÉRATEURS DANS UN RÉSEAU PNEUMATIQUE, HYDRAULIQUE OU ÉLECTRIQUE

(30) Priorität: 26.01.2010 DE 102010001198
(43) Veröffentlichungstag der Anmeldung: 05.12.2012
(73) Patentinhaber: Robert Bosch GmbH, 70442 Stuttgart (DE)
(72) Erfinder: SCHOEPF, Friedrich, 75447 Sternenfels-Diefenbach (DE); BRANDSTETTER, Markus, 74343 Sachsenheim (DE)
(86) Internationale Anmeldenummer: PCT/EP2010/069603
(87) Internationale Veröffentlichungsnummer: WO 2011/091906

(56) Entgegenhaltungen:
- EP-A1- 2 026 299
- WO-A2-2009/103998
- US-A- 4 858 141
- US-A- 5 483 153
- HART G W: "NONINTRUSIVE APPLIANCE LOAD MONITORING", PROCEEDINGS OF THE IEEE, IEEE. NEW YORK, US, Bd. 80, Nr. 12, 1. Dezember 1992 (1992-12-01), Seiten 1870-1891, XP000336363, ISSN: 0018-9219, DOI: 10.1109/5.192069

## Beschreibung

### Stand der Technik

Die Erfindung betrifft ein Verfahren zur Identifikation von Verbrauchern bzw. Erzeugern in einem pneumatischen, hydraulischen oder elektrischen Netz nach dem Oberbegriff des Anspruchs 1.

Ein derartiges Verfahren ist aus der WO 2009/103998 A2 bekannt. Bei dem bekannten Verfahren werden Ein- bzw. Ausschaltvorgänge von Verbrauchern erfasst, wobei anhand abgespeicherter Vergleichsprofile eine Zuordnung der Ein-und Ausschaltvorgänge zu einem bestimmten Verbraucher ermöglicht werden soll. Ein derartiges Verfahren arbeitet immer dann zufriedenstellend, wenn es darum geht, unterschiedliche Verbraucher mit entsprechend unterschiedlichen Vergleichsprofilen voneinander zu unterscheiden. Sind jedoch mehrere gleiche Verbraucher vorhanden, kann alleine anhand des Vergleichsprofils nicht ohne Weiteres auf einen bestimmten von mehreren gleichen Verbrauchern geschlossen werden.

Aus der EP 2 026 299 A1 und dem US 5,483,153 sind darüber hinaus ähnliche Verfahren nach dem Oberbegriff des Anspruchs 1 bekannt, die jedoch ebenfalls nicht dazu geeignet sind, bei gleichen Verbrauchern auf einfache Art und Weise eine (örtliche) Zuordnung zu einem bestimmten Verbraucher zu ermöglichen.

Darüber hinaus ist es aus dem Stand der Technik bekannt, die Gesamtleistungsaufnahme von elektrischen Verbrauchern wird bei elektrischen Netzen beispielsweise mittels einer zentralen Steuereinheit über den Zeitverlauf zu erfassen und aufzuzeichnen. Bei den elektrischen Verbrauchern kann es sich beispielsweise um Elektrogeräte oder Maschinen handeln, die in einem Fabrikgebäude an den unterschiedlichsten Stellen angeordnet sind. Dabei ist der Gebrauch bzw. das Ein- und Ausschalten der elektrischen Geräte oder Maschinen oftmals automatisiert. Will man nun den Gesamtenergiebedarf des Gebäudes bzw. des Systems minimieren, so ist es wichtig zu wissen, wann welches Gerät bzw. welche Maschine an- bzw. ausgeschaltet wird. Oftmals ist dabei festzustellen, dass Geräte bzw. Maschinen eingeschaltet sind, obwohl diese überhaupt nicht gebraucht werden. Dies ist beispielsweise dann festzustellen, wenn Geräte z.B. am Wochenende oder in Ferienzeiten arbeiten, obwohl keine Nutzer die Geräte benötigt. Bei dem zuletzt erwähnten Stand der Technik wird zwar z.B. der Leistungsverbrauch einer Gesamtzahl von elektrischen Geräten oder Maschinen in einem Netz mittels der zentralen Steuereinheit erfasst, die Zuordnung einzelner Geräte oder Maschinen zu der Leistungskurve oder zu Leistungsspitzen ist jedoch nicht ohne Weiteres möglich. Daher wird beim Stand der Technik dies z.B. durch Begehungen durch qualifiziertes Personal vorgenommen, das sich einen Überblick über die verwendeten elektrischen Geräte und Maschinen verschafft und versucht, den Kurvenverlauf der Leistungsaufnahme des gesamten Systems den einzelnen Geräten bzw. Maschinen zuzuordnen. Dies ist beispielsweise dadurch erschwert, dass ein Zugang bzw. Zutritt zu den einzelnen elektrischen Geräten oder Maschinen nur zu bestimmten Zeiten (z.B. werktags, und dann nur tagsüber) ohne Weiteres möglich ist, ansonsten ist dies mit zum Teil bedeutenden Mehrkosten verbunden.

### Offenbarung der Erfindung

Ausgehend von dem dargestellten Stand der Technik liegt der Erfindung die Aufgabe zugrunde, ein Verfahren zur Identifikation von Verbrauchern bzw. Erzeugern in einem pneumatischen, hydraulischen oder elektrischen Netz nach dem Oberbegriff des Anspruchs 1 derart weiterzubilden, dass eine zumindest weitgehend automatische örtliche Zuordnung auch bei an sich gleichen pneumatischen, hydraulischen oder elektrischen Verbrauchern im Netz ermöglicht wird. Diese Aufgabe wird mit einem Verfahren zur Identifikation von Verbrauchern bzw. Erzeugern in einem pneumatischen, hydraulischen oder elektrischen Netz mit den Merkmalen des Anspruchs 1 gelöst. Bei der Umsetzung der Erfindung ist es insbesondere wichtig, dass die Messgröße geeignet ist, einen Ein- bzw. Ausschaltvorgang eines Verbrauchers bzw. Erzeugers sicher erkennen zu können sowie es möglich ist, anhand des Messwertes eine Zuordnung der Messwerte zu einem bestimmten Verbraucher bzw. Erzeuger vornehmen zu können. Erfindungsgemäß ist es vorgesehen, dass aufgrund des Verlaufs der Messgröße auf eine örtliche Distanz zu einer Messwertaufnahmeeinheit geschlossen wird. Dadurch, dass auf eine örtliche Distanz zu einer Messwertaufnahmeeinheit geschlossen werden kann, ist eine retativ einfache Zuordnung der einzelnen Ein- bzw. Ausschattvorgänge zu einem bestimmten Verbraucher bzw. Erzeuger möglich. Die Zuordnung ist deshalb so wichtig, da nur anhand der Zuordnung entschieden werden kann, ob z.B. ein Ein- bzw. Ausschaltvorgang des Verbrauchers bzw. Erzeugers zu einem bestimmten Zeitpunkt notwendig bzw. erforderlich ist.

Vorteilhafte Weiterbildungen des erfindungsgemäßen Verfahrens zur Identifikation von Verbrauchern bzw. Erzeugern in einem pneumatischen, hydraulischen oder elektrischen Netz sind in den Unteransprüchen angegeben.

In einer vorteilhaften Ausgestaltung der Erfindung kann es vorgesehen sein, dass bei einer Abweichung des tatsächlich erfassten zeitlichen Verlaufs der Messgröße von in der zentralen Steuereinheit abgespeicherten zeitlichen Verläufen der tatsächlich erfasste zeitliche Verlauf anhand von Wahrscheinlichkeitskriterien einem speziellen Verbraucher bzw. Erzeuger zugeordnet wird. Dadurch wird das Identifikationsverfahren gegenüber Störeinflüssen unempfindlicher bzw. kann sich beispielsweise bei (geringfügigen) zeitlichen Veränderungen des Verbrauchers bzw. Erzeugers, z.B. infolge Alterung oder Toleranzen, einfach an die tatsächlichen Gegebenheiten adaptieren.

Zur Auswertung der Darstellung der erfassten Messgrößen, um diese durch z.B. einen Energieberater richtig interpretieren zu können, ist es darüber hinaus vorteilhaft, wenn die zentrale Steuereinheit zumindest mit einer Ausgabeeinheit gekoppelt ist, die wenigstens den zeitlichen Verlauf der erfassten Ein- und Ausschaltvorgänge und die den Ein- und Ausschaltvorgängen zugeordneten Verbraucher bzw. Erzeugers darstellt.

Insbesondere bei einer Neuinstallation bzw. bei einem erstmaligen Durchlauf des Verfahrens ist es darüber hinaus vorteilhaft, wenn der zentralen Steuereinheit über eine Eingabeeinheit Kenngrößen bekannter Verbraucher bzw. Erzeuger angegeben werden, anhand deren die Steuereinheit den Vergleich mit den tatsächlich erfassten zeitlichen Messwertverläufen vornimmt oder als zusätzliche Datenbasis zur Verifikation von Verbrauchern bzw. Erzeugern heranzieht. Dadurch wird eine besonders sichere und schnelle Erkennung der Verbraucher bzw. Erzeuger ermöglicht.

Gerade bei der Einrichtung der zentralen Steuereinheit ist es darüber hinaus besonders vorteilhaft, wenn die zentrale Steuereinheit mittels eines bekannten Eichgerätes und einer bekannten Distanz kalibriert wird. Dadurch wird die Genauigkeit der erfassten Messgrößen vergrößert und die Wahrscheinlichkeit der richtigen Zuordnung der Messwertverläufe zu den einzelnen Verbrauchern bzw. Erzeugern erhöht.

Weitere Vorteile, Merkmale und Einzelheiten der Erfindung ergeben sich aus der nachfolgenden Beschreibung bevorzugter Ausführungsbeispiele sowie anhand der Zeichnungen.

Diese zeigen in:
- Fig. 1: eine Darstellung der Leistungsaufnahme in einem Stromnetz während mehrerer Tage,
- Fig. 2: eine Darstellung der Leistungsaufnahme typischer elektrischer Verbraucher wenn diese ein- bzw. ausschaltet werden,
- Fig. 3: eine vereinfachte Darstellung eines Stromnetzes,
- Fig. 4: ein Flussdiagramm zur Darstellung des erfindungsgemäßen Verfahrens und
- Fig. 5: eine Darstellung zur Erläuterung des unterschiedlichen zeitlichen Messwertverlaufes bei ein und demselben Gerät bei unterschiedlichen Leitungslängen.

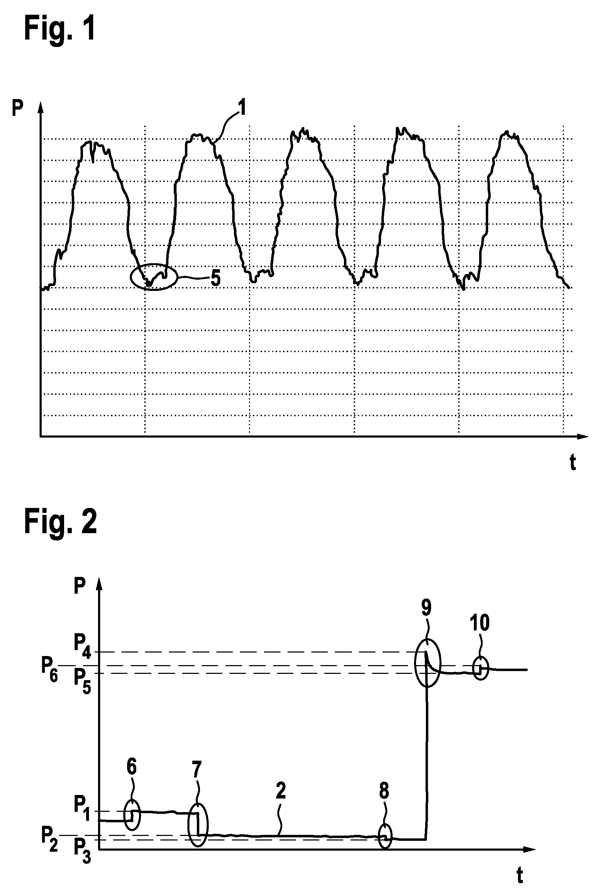

In der Fig. 1 ist mit der Kurve 1 der Verlauf der Leistungsaufnahme P über der Zeit t in einem elektrischen Netz dargestellt, wobei eine Vielzahl von Verbrauchern Bestandteil des elektrischen Netzes sind. Hierbei ist der zeitliche Verlauf über insgesamt fünf Tage dargestellt, mit jeweiligen Leistungsmaxima während der Mittagszeit sowie Leistungsminima während der Nachtstunden. Wie man insbesondere anhand des Bereiches 5 der Kurve 1 erkennt, sind während der Nachtstunden mehrere Ein- und Ausschaltvorgänge von Verbrauchern registriert worden, die zu Leistungsspitzen bzw. Leistungsminima führen.

In der Fig. 2 ist mit der Kurve 2 die Leistungsaufnahme P von elektrischen Verbrauchern über der Zeit t dargestellt, wobei die elektrischen Verbraucher jeweils einzeln an- bzw. ausgeschaltet werden. Hierbei ist für jedes Ein- bzw. Ausschalten eines Verbrauchers ein charakteristischer Verlauf der Kurve 2 aufgezeichnet, der mittels des nachfolgend noch näher beschriebenen Verfahrens erkannt wird und so jedem Ein- bzw. Ausschalten einem speziellen Verbraucher zuordenbar ist. So erkennt man in dem ersten Bereich 6 der Kurve 2 das Einschalten eines Gebläses, was mit einer typischen, nahezu senkrechten Steigerung der Leistungsaufnahme P auf einen Wert P₁ gekennzeichnet ist. Später erkennt man in einem zweiten Bereich 7 das Abschalten eines Kühlschrankes, was ebenfalls zu einem typischen Leistungsverhalten, nämlich einem typischen Leistungsabfall in dem Netz auf den Wert P₂ führt. In einem dritten Bereich 8 erkennt man das Reduzieren des Gebläses von einer ersten, relativ hohen Leistung auf einen reduzierten Betrieb, was sich in einer geringen Verminderung der Leistungsaufnahme des Netzes auf der Wert P₃ widerspiegelt. In einem vierten Bereich 9 erkennt man die sprunghafte Steigerung der Leistungsaufnahme P, verursacht durch das Einschalten eines Toasters auf den Wert P₄. Ferner erkennt man, dass nach dem Einschalten des Toasters die Leistungsaufnahme P über einen charakteristisch abfallenden Kurvenverlauf auf den Betrag P₅ abnimmt. Zuletzt erkennt man in einem fünften Bereich 10 eine Zunahme der Leistungsaufnahme P auf den Wert P₆ mit einem kurz danach stattfindendem Abfall der Leistungsaufnahme P, was charakteristisch für das Einschalten eines Lichtes ist.

Somit erkennt man anhand der Fig. 2, dass für jeden Ein- bzw. Ausschaltvorgang eines elektrischen Verbrauchers ein charakteristischer Verlauf der Kurve 2 der Leistungsaufnahme P erfasst wird, welcher mittels des erfindungsgemäßen Verfahrens erkannt werden soll bzw. dem speziellen Verbraucher zugeordnet werden soll.

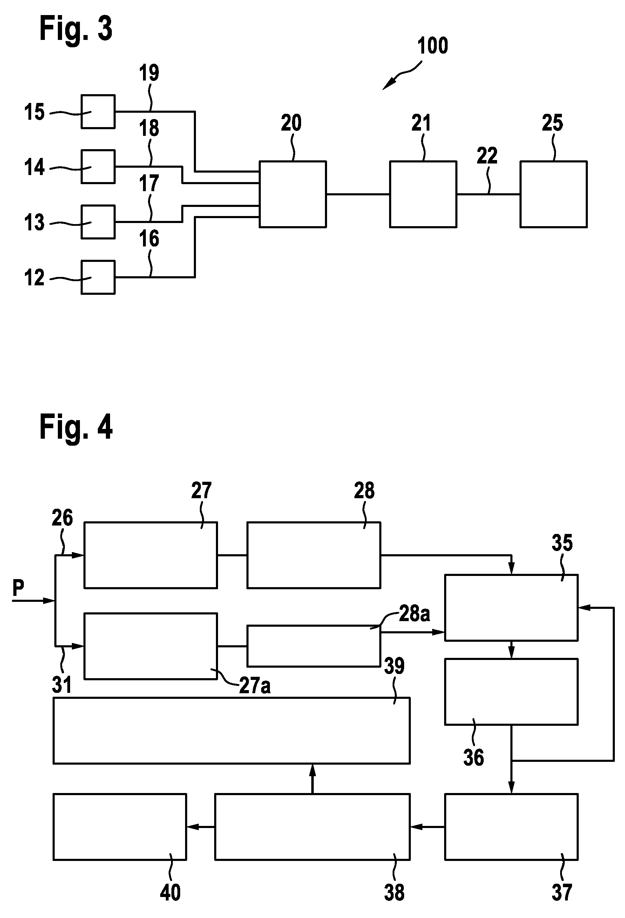

Zur Erläuterung des erfindungsgemäßen Verfahrens wird nunmehr zunächst auf die Fig. 3 verwiesen, welche insgesamt in schematischer Weise ein Stromnetz 100 darstellt. Hierbei handelt es sich bei dem Stromnetz 100 insbesondere um ein Stromnetz 100 innerhalb eines örtlich begrenzten Bereiches, z.B. innerhalb eines Hauses oder eines Fabrikgebäudes. Das Stromnetz 100 weist beispielhaft vier Verbraucher 12 bis 15 auf, die über Leitungen 16 bis 19 mit Spannung bzw. Strom versorgt werden. Charakteristisch ist weiterhin, dass jede der Leitungen 16 bis 19, bezogen auf die Entfernung zu einem als Messwertaufnahmeeinheit ausgebildeten Stromverteiler 20, eine charakteristische Länge aufweist, die insbesondere vom Standort des Verbrauchers 12 bis 15 abhängig ist. An den Stromverteiler 20 ist eine zentrale Steuereinheit 21 angeschlossen, die insbesondere die Schaltvorgänge der einzelnen Verbraucher 12 bis 15 erfasst. Hierbei kann die Erfassung der einzelnen Schaltvorgänge insbesondere in dem Erfassen der Leistungsaufnahme bzw. der Gesamtleistung an dem Stromverteiler 20 entsprechend den Fig. 1 und 2 erfolgen.

Die zentrale Steuereinheit 21 ist über eine Leitung 22 einer optionalen Ein-/Ausgabeeinheit 25 gekoppelt. Die Ein-/Ausgabeeinheit 25 umfasst insbesondere eine (nicht dargestellte) Eingabetastatur sowie Ausgabemöglichkeiten in Form z.B. eines Bildschirmes oder eines sonstigen geeigneten Einrichtung, die die von der zentralen Steuereinheit 21 erfassten Messgrößen darstellt bzw. dokumentiert. In der zentralen Steuereinheit 21 sind optional zusätzlich für die Ein- bzw. Ausschaltvorgänge der Verbraucher 12 bis 15 Einschalt- bzw. Ausschaltprofile abgespeichert. Die Einschalt- bzw. Ausschaltprofile können auch auf andere Art und Weise (z.B. mittels Funk) übertragen werden.

In dem Flussdiagramm der Fig. 4 ist eine Messgröße, beispielhaft eine elektrische Leistung P, als Eingangsgröße dargestellt, die der zentralen Steuereinheit 21 zugeführt wird. In einem ersten Ast 26 des Flussdiagramms wird durch den ersten Prozessschritt 27 ein Einschalten eines der Verbraucher 12 bis 15 identifiziert. In einem zweiten Prozessschritt 28 wird die Leistungsaufnahme des Verbrauchers 12 bis 15 gemessen, d.h. dessen zeitlicher Verlauf mittels eines Einschaltprofils aufgezeichnet. Parallel zum ersten Ast 26 wird in einem zweiten Ast 31 in einem ersten Prozessschritt 27a das Ausschalten eines der Verbraucher 12 bis 15 erkannt. In einem zweiten Prozessschritt 28a wird ebenfalls der zeitliche Verlauf der Leistungsaufnahme des Stromnetzes 100 aufgezeichnet, so dass ein Ausschaltprofil des Verbrauchers 12 bis 15 ermittelt wird.

Die Ergebnisse der zweiten Prozessschritte 28 und 28a, d.h. das ermittelte Einschaltprofil bzw. Ausschaltprofil der Verbraucher 12 bis 15 wird anschließend in einem weiteren, dritten Prozessschritt 35 mit in der zentralen Steuereinheit 21 abgespeicherten Einschaltprofilen bzw. Ausschaltprofilen der Verbraucher 12 bis 15 verglichen, um aus dem ermittelten speziellen Einschaltprofil bzw. Ausschaltprofil auf einen speziellen Verbraucher 12 bis 15 schließen zu können. Sollte dies nicht direkt möglich sein, wird in einem vierten Prozessschritt 36 das tatsächlich aufgenommene Einschaltprofil bzw. Ausschaltprofil (oder alternativ hierzu die abgespeicherten Einschaltprofile bzw. Ausschaltprofile) derart modifiziert, dass unterschiedliche Längen L der Leitungen 16 bis 19 simuliert werden. Die nun modifizierten Einschaltprofile bzw. Ausschaltprofile führen gegebenenfalls direkt zu einem speziellen Verbraucher 12 bis 15. Dies ist insbesondere dann möglich, wenn über die Ein-/Ausgabeeinheit 25 vorab charakteristische Einschaltprofile bzw. Ausschaltprofile der Verbraucher 12 bis 15 abgespeichert sind. Weiterhin wird dies erleichtert, wenn vor Inbetriebnahme des Stromnetzes 100 mittels eines Kalibriergerätes sowie einer bekannten Distanz zwischen dem Kalibriergerät und der zentralen Steuereinheit 21 ein Einschalten sowie Ausschalten simuliert wird, um damit in der zentralen Steuereinheit 21 Messkurven anzulegen, welche die Simulation verschiedener Längen L der Leitungen 16 bis 19 erleichtern.

Als Ergebnis des vierten Prozessschrittes 36 wird in einem fünften Prozessschritt 37 entweder der spezielle Verbraucher 12 bis 15 identifiziert, oder aber es wird ein Vorschlag für einen bestimmten Gerätetyp bzw. eine bestimmte Entfernung des Gerätetyps von der zentralen Steuereinheit 21 vorgeschlagen, der von einem Bediener bestätigt oder verworfen werden kann, um damit einen speziellen Verbraucher 12 bis 15 zu identifizieren bzw. zu verwerfen.

In einem Block 38 werden die Ergebnisse der Ein- bzw. Ausschaltvorgänge des Stromnetzes 100 aufbereitet und Paarungen der Ein- und Ausschaltvorgänge sowie sich daraus ergebende Einschaltdauern der Verbraucher 12 bis 15 ermittelt. Die Ergebnisse (insbesondere Liste der gefundenen Geräte, Angaben zum Ein- bzw. Ausschalten der Geräte, Gerätetyp und Entfernung) werden in einem Schritt 39 mittels der Ein-/Ausgabeeinheit 25 dargestellt. Hierbei kann es gegebenenfalls in einem Schritt 40 vorgesehen sein, dass die zentrale Steuereinheit 21 Vorschläge bezüglich sinnvoller Einschalt- und Ausschaltvorgänge bzw. zur Energieoptimierung der Verbraucher 12 bis 15 vorgibt.

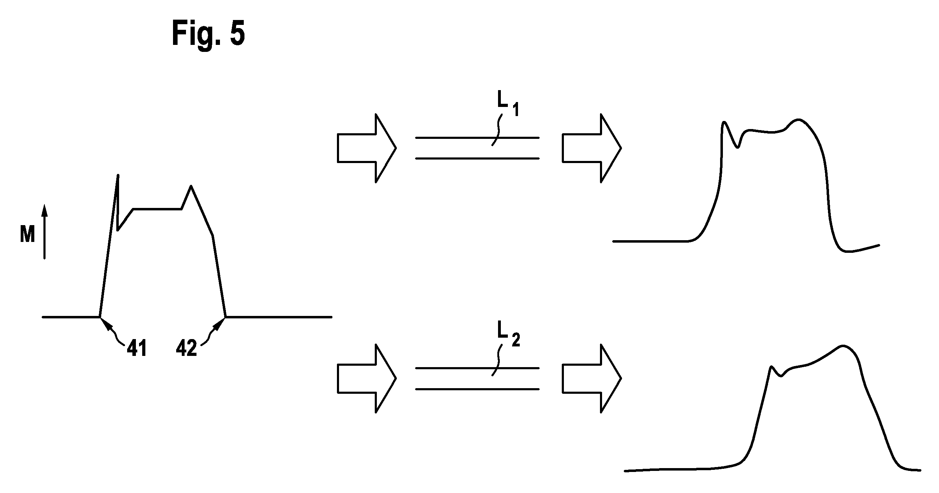

In der Fig. 5 ist der zeitliche Verlauf einer Messgröße M dargestellt, wie sie sich direkt an einem Verbraucher einstellt. Hierbei ist ein Einschaltereignis 41 und ein Ausschaltereignis 42 dargestellt, welches zu entsprechenden Veränderungen der Messgröße M führt. Zwischen dem Einschaltereignis 41 und dem Ausschaltereignis 42 ist der Verbraucher eingeschaltet. In Abhängigkeit unterschiedlicher Leitungslängen L₁ bzw. L₂ zwischen dem Verbraucher und zum Beispiel der zentralen Steuereinheit 21 ergeben sich nun unterschiedliche Verläufe der Messgrößen M₁ bzw. M₂. So erkennt man, dass bei einer längeren Leitungslänge L₂ der zeitliche Verlauf der Messgröße M₂ verzögert wird. Gleichzeitig ist auch die Messgröße M₂ in ihrem Verlauf gegenüber der Messgröße M₁ bei einer kleinen Leitungslänge L₁ geringfügig verändert. Diese Erkenntnisse dienen bei der Simulation unterschiedlicher Leitungslängen L dazu, die erfassten Einschalt- bzw. Ausschaltprofile mit verschiedenen Leitungslängen L simulieren zu können, um damit auf eine bestimmte Distanz eines Verbrauchers (insbesondere eines Verbrauchers 12 bis 15) zu der zentralen Steuereinheit 21 schließen zu können.

Im Rahmen der Beschreibung bzw. des Ausführungsbeispiels wurde von einem Stromnetz 100 ausgegangen, d.h., dass die Verbraucher 12 bis 15 elektrische Verbraucher 12 bis 15 sind. Es liegt jedoch im Rahmen der Erfindung, dass anstelle elektrischer Verbraucher 12 bis 15 auch pneumatische oder hydraulische Verbraucher mittels des beschriebenen erfindungsgemäßen Verfahrens erkannt bzw. lokalisiert werden können. Ferner wird erwähnt, dass bezüglich der Art der Messgröße alle charakteristischen Messgrößen für den jeweiligen Verbraucher 12 bis 15 sinnvoll bzw. denkbar sind, die eine Identifikation des speziellen Verbrauchers 12 bis 15 ermöglichen. Insbesondere bei pneumatischen bzw. hydraulischen Verbrauchern können dies beispielsweise auch der Volumenstrom, der pneumatische bzw. hydraulische Druck oder sonstige Messgrößen sein.

Weiterhin wird erwähnt, dass die Erfindung im Rahmen von Verbrauchern dargestellt bzw. erläutert wurde. Die Erfindung ist jedoch nicht auf die Identifikation von Verbrauchern beschränkt, sondern kann auch auf die Identifikation von Erzeugern übertragen werde bzw. umfasst auch pneumatische, hydraulische oder elektrische Netze, bei denen sowohl Verbraucher als auch Erzeuger vorhanden sind.

## Patentansprüche

1. Verfahren zur Identifikation von Verbrauchern (12 bis 15) bzw. Erzeugern in einem pneumatischen, hydraulischen oder elektrischen Netz (100), bei dem eine zentrale Steuereinheit (21) Ein- bzw. Ausschaltvorgänge der Verbraucher (12 bis 15) bzw. Erzeuger erfasst und die Ein- und Ausschaltvorgänge Verbrauchern (12 bis15) bzw. Erzeugern zugeordnet werden, wobei in der zentralen Steuereinheit (21) Vergleichsprofile von Verbrauchern (12 bis 15) bzw. Erzeugern abgespeichert sind, wobei jeder erfasste Ein- bzw. Ausschaltvorgang mit den abgespeicherten Vergleichsprofilen verglichen wird, wobei der erfasste Ein- bzw. Ausschaltvorgang einem bestimmten Verbraucher (12 bis 15) bzw. Erzeuger zumindest mit einer bestimmten Wahrscheinlichkeit zugeordnet wird, und wobei während des Ein- bzw. Ausschaltvorgangs des Verbrauchers (12 bis 15) bzw. Erzeugers der zeitliche Verlauf einer Messgröße (M), insbesondere eines Strom- oder Spannungsverlaufs, einer Leistungsaufnahme (P) oder eines pneumatischen oder hydraulischen Druckverlaufs oder Volumenstroms erfasst wird,
**dadurch gekennzeichnet,**
**dass** aufgrund des Verlaufs der Messgröße (M) auf eine örtliche Distanz zu einer Messwertaufnahmeeinheit (20) geschlossen wird.

2. Verfahren nach Anspruch 1,
**dadurch gekennzeichnet,**
**dass** bei einer Abweichung des tatsächlich erfassten zeitlichen Verlaufs der Messgröße (M) von in derzentralen Steuereinheit (21) abgespeicherten zeitlichen Verläufen der tatsächlich erfasste zeitliche Verlauf anhand von Wahrscheinlichkeitskriterien einem speziellen Verbraucher (12 bis 15) bzw. Erzeuger zugeordnet wird.

3. Verfahren nach Anspruch 1 oder 2,
**dadurch gekennzeichnet,**
**dass** der zeitlich erfasste Verlauf des Messwerts (M) zu den in der zentralen Steuereinheit (21) bereits abgespeicherten Verläufen hinzugefügt wird.

4. Verfahren nach einem der Ansprüche 1 bis 3,
**dadurch gekennzeichnet,**
**dass** die zentrale Steuereinheit (21) zumindest mit einer Ausgabeeinheit (25) gekoppelt ist, die wenigstens den zeitlichen Verlauf der erfassten Ein- und Ausschaltvorgänge und die den Ein- und Ausschaltvorgängen zugeordneten Verbraucher (12 bis 15) bzw. Erzeuger darstellt.

5. Verfahren nach einem der Ansprüche 1 bis 4,
**dadurch gekennzeichnet,**
**dass** der zentralen Steuereinheit (21) über eine Eingabeeinheit Kenngrößen bekannter Verbraucher (12 bis 15) bzw. Erzeuger eingegeben werden, anhand deren die Steuereinheit (21) den Vergleich mit den tatsächlich erfassten zeitlichen Messwertverläufen vornimmt oder als zusätzliche Datenbasis zur Verifikation von Verbrauchern (12 bis 15) bzw. Erzeugern heranzieht.

6. Verfahren nach Anspruch 2,
**dadurch gekennzeichnet,**
**dass** beim Vorhandensein mehrerer möglicher Verbraucher (12 bis 15) bzw. Erzeuger zu einem tatsächlich erfassten zeitlichen Verlauf eines Messwerts (M) die zentrale Steuereinheit (21) die möglichen Alternativen darstellt und eine Zuordnung manuell vorgenommen wird.

7. Verfahren nach einem der Ansprüche 1 bis 6,
**dadurch gekennzeichnet,**
**dass** die zentrale Steuereinheit (21) mittels eines bekannten Eichgerätes und einer bekannten Distanz (L) kalibriert wird.

8. Verfahren nach Anspruch 4,
**dadurch gekennzeichnet,**
**dass** die zentrale Steuereinheit (21) zusätzlich zumindest Optimierungsvorschläge zur Minimierung des Energieverbrauches der Verbraucher (12 bis 15) bzw. Erzeuger ausgibt.

## Claims

1. Method for identifying loads (12 to 15) or generators in a pneumatic, hydraulic or electrical network (100), in which a central control unit (21) detects switch-on and switch-off processes in the loads (12 to 15) or generators and the switch-on and switch-off processes are associated with loads (12 to 15) or generators, wherein the central control unit (21) has comparison profiles stored in it for loads (12 to 15) or generators, wherein each detected switch-on or switch-off process is compared with the stored comparison profiles, wherein the detected switch-on or switch-off process is associated with a particular load (12 to 15) or generator at least with a particular probability, and wherein during the switch-on or switch-off process in the load (12 to 15) or generator, the temporal characteristic of a measured variable (M), particularly of a current or voltage characteristic, of a power draw (P) or of a pneumatic or hydraulic pressure characteristic or volume current is detected,
**characterized**
**in that** the characteristic of the measured variable (M) is taken as a basis for inferring a local distance to a measured value recording unit (20).

2. Method according to Claim 1,
**characterized**
**in that** a deviation in the actually detected temporal characteristic of the measured variable (M) from temporal characteristics that are stored in the central control unit (21) prompts the actually detected temporal characteristic to be associated with a specific load (12 to 15) or generator on the basis of probability criteria.

3. Method according to Claim 1 or 2,
**characterized**
**in that** the characteristic of the measured value (M) that is captured over time is added to the characteristics that are already stored in the central control unit (21).

4. Method according to one of Claims 1 to 3,
**characterized**
**in that** the central control unit (21) is coupled at least to an output unit (25) that presents at least the temporal characteristic of the detected switch-on and switch-off processes and the loads (12 to 15) or generators associated with the switch-on and switch-off processes.

5. Method according to one of Claims 1 to 4,
**characterized**
**in that** the central control unit (21) has parameters from known loads (12 to 15) or generators input into it via an input unit, which parameters the control unit (21) takes as a basis for performing the comparison with the actually detected temporal measured value characteristics or uses as an additional database for verifying loads (12 to 15) or generators.

6. Method according to Claim 2,
**characterized**
**in that** when there are multiple possible loads (12 to 15) or generators present, the central control unit (21) presents the possible alternatives for an actually detected temporal profile of a measured value (M), and an association is made manually.

7. Method according to one of Claims 1 to 6,
**characterized**
**in that** the central control unit (21) is calibrated by means of a known calibration device and a known distance (L).

8. Method according to Claim 4,
**characterized**
**in that** the central control unit (21) additionally outputs at least optimization proposals for minimizing the power consumption of the loads (12 to 15) or generators.

## Revendications

1. Procédé d'identification de consommateurs (12 à 15) ou de générateurs dans un réseau (100) pneumatique, hydraulique ou électrique, avec lequel une unité de commande centrale (21) détecte des processus de mise en circuit ou hors circuit des consommateurs (12 à 15) ou des générateurs et des consommateurs (12 à 15) ou des générateurs sont associés aux processus de mise en circuit ou hors circuit, des profils comparatifs de consommateurs (12 à 15) ou de générateurs étant mis en mémoire dans l'unité de commande centrale (21), chaque processus de mise en circuit ou hors circuit détecté étant comparé avec les profils comparatifs mis en mémoire, un consommateur (12 à 15) ou un générateur donné étant associé au processus de mise en circuit ou hors circuit détecté au moins avec une probabilité donnée, et la courbe dans le temps d'une grandeur de mesure (M), notamment d'une courbe de courant ou de tension, d'une puissance consommée (P) ou d'une courbe de pression ou d'un débit volumique pneumatique ou hydraulique étant acquise pendant le processus de mise en circuit ou hors circuit du consommateur (12 à 15) ou du générateur,
**caractérisé en ce**
**qu'**une distance locale par rapport à une unité d'acquisition de valeur mesurée (20) est déduite en se basant sur la courbe de la valeur de mesure (M).

2. Procédé selon la revendication 1, **caractérisé en ce qu'**en présence d'un écart entre la courbe dans le temps effectivement acquise de la grandeur de mesure (M) et les courbes dans le temps mises en mémoire dans l'unité de commande centrale (21), la courbe dans le temps effectivement acquise est associée à un consommateur (12 à 15) ou un générateur spécial au moyen de critères de probabilité.

3. Procédé selon la revendication 1 ou 2, **caractérisé en ce que** la courbe dans le temps acquise de la valeur mesurée (M) est ajoutée aux courbes déjà mises en mémoire dans l'unité de commande centrale (21).

4. Procédé selon l'une des revendications 1 à 3, **caractérisé en ce que** l'unité de commande centrale (21) est connectée à au moins une unité de sortie (25) qui représente au moins la courbe dans le temps des processus de mise en circuit et hors circuit détectés et des consommateurs (12 à 15) ou des générateurs associés aux processus de mise en circuit et hors circuit.

5. Procédé selon l'une des revendications 1 à 4, **caractérisé en ce que** des grandeurs caractéristiques des consommateurs (12 à 15) ou des générateurs connus sont saisies dans l'unité de commande centrale (21) par le biais d'une unité de saisie, à l'aide desquelles l'unité de commande (21) effectue la comparaison avec les courbes dans le temps effectivement acquises ou les utilise en tant que base de données supplémentaire pour la vérification des consommateurs (12 à 15) ou des générateurs.

6. Procédé selon la revendication 2, **caractérisé en ce qu'**en présence de plusieurs consommateurs (12 à 15) ou générateurs possibles pour une courbe dans le temps effectivement acquise d'une valeur mesurée (M), l'unité de commande centrale (21) représente les variantes possibles et une association est effectuée manuellement.

7. Procédé selon l'une des revendications 1 à 6, **caractérisé en ce que** l'unité de commande centrale (21) est calibrée à l'aide d'un appareil d'étalonnage connu et d'une distance (L) connue.

8. Procédé selon la revendication 4, **caractérisé en ce que** l'unité de commande centrale (21) délivre en plus au moins des propositions d'optimisation en vue de réduire au minimum la consommation d'énergie des consommateurs (12 à 15) ou des générateurs.
